# EUROPEAN PATENT APPLICATION

(11) **EP 1 542 280 A1**
(43) Date of publication of application: **15.06.2005**
(21) Application number: 03741247.5
(22) Date of filing: 07.07.2003
(51) Int. Cl.: H01L 23/36, H01L 23/373

(54) **MEMBER FOR SEMICONDUCTOR DEVICE**

(30) Priority: 17.07.2002 JP 2002207702; 02.04.2003 JP 2003098759
(71) Applicant: SUMITOMO ELECTRIC INDUSTRIES, Ltd, Osaka-shi, Osaka 541-0041 (JP)
(72) Inventor: KAMITAKE, Kazuya Itami Works of Sumitomo Electric, Itami-shi, Hyogo 664-0016 (JP); ABE, Yugaku, Itami Works of Sumitomo Electric Ind., Itami-shi, Hyogo 664-0016 (JP); HIGAKI, Kenjiro Itami Works of Sumitomo Electric, Itami-shi, Hyogo 664-0016 (JP)
(74) Representative: Cross, Rupert Edward Blount
(86) International application number: PCT/JP2003/008624
(87) International publication number: WO 2004/008530

(57) **Abstract**

There is provided a member for a semiconductor device, such as a substrate, having an excellent resin bonding property capable of improving resin bonding strength at the time the member for a semiconductor device being bonded with resin and maintaining a high resin bonding strength even after various reliability tests, such as a thermal cycling test, are performed. The member for a semiconductor device comprises a base member 1 made of an alloy or composite mainly composed of Cu and W and/or Mo, an alloy or composite mainly composed of Al-SiC, or an alloy or composite mainly composed of Si-SiC. A coating layer made of a hard carbon film 2 is provided on at least a surface of the base member 1 on which at least another member for the semiconductor device, such as a package, is bonded with a resin. It is preferable that the base member 1 have a surface roughness of 0.1 to 20 µm in Rmax. It is preferable that the hard carbon film 2 have a thickness of 0.1 to 10 µm.

## Description

### Technical Field

The present invention relates to a member used for a heat sink, a radiating substrate, a housing, or the like constituting a semiconductor device, and more particularly, a member for a semiconductor device having an excellent resin bonding property and a semiconductor device using the same.

### Background Art

When a material constituting a substrate, which is one of the members for a semiconductor device, is combined with a member for another device, it is necessary that distortion due to thermal stress does not occur in the interface between the combined members. For this reason, the thermal expansion coefficient of the substrate material must not be largely different from those of other members for the semiconductor device, such as semiconductor elements or packages. In particular, as the semiconductor device has recently been made small and lightweight, the radiating substrate is required to be made of a material of a high thermal conductivity, the thermal expansion coefficient not being largely different from those of the semiconductor elements or package, or the like, and light weight.

As a suitable substrate material satisfying these requirements, there is known an alloy or composite mainly composed of Cu and W and/or Mo, that is, a Cu-W or Cu-Mo alloy or composite. In addition, there are known an alloy or composite mainly composed of Al-SiC and having SiC particles dispersed in Al or an Al alloy, and an alloy or composite mainly composed of Si-SiC and having SiC particles dispersed in Si or an SiC alloy.

In addition, the member for a semiconductor device, including the radiating substrate, is required to have high corrosion resistance. However, an alloy or composite itself constituting the member does not have corrosion resistance. Therefore, conventionally, a plating layer of Ni or Au or others was provided on the surface of the alloy or composite. The plating layer has also been needed to maintain wettability or bonding strength during a conventional process of soldering the substrate material with a package material, or the like.

However, recently, instead of the soldering method, a resin bonding method has been widely used as a method of bonding the radiating substrate to the package, or the like because the resin bonding method is inexpensive and can be performed at a low temperature. In a conventional package, etc. using a resin, before the plating, the radiating substrate and other members for a semiconductor device, such as a lead frame, are bonded by using a method, such as a transfer molding method, and then, subjected to the plating. However, in a recent method, the radiating substrate, for example, is subjected to the plating in advance, and then, bonded to the package substrate with a liquid resin of epoxy or polyimide or a sheet-shaped resin or others.

The problem with the resin bonding method is that, since Ni or Au conventionally used as the plating layer has an inferior resin bonding property, a required bonding strength cannot be obtained. In particular, after various reliability tests, such as a thermal cycling test for performing alternate exposure to temperatures of 150°C and -65°C, a PCT (pressure cooker test) performed under a condition of 121°C, 100% RH (relative humidity), and 2 atm, and an HAST (highly accelerated stress test) performed under a condition of 131°C, 85% RH, and 2 atm, the resin bonding strength is severely deteriorated.

On the other had, metallic materials having an excellent resin bonding property include Al and Cu on the surface of which a naturally oxidized film can be easily formed. However, in Al and Cu, the bonding strength between the naturally oxidized film and the resin is not sufficient, particularly after the aforementioned various reliability tests. In addition, the alloy or composite itself mainly composed of Cu and W and/or Mo, such as Cu-W and Cu-Mo, could not achieve satisfactory resin bonding strength. This is because the alloy or composite mainly composed of Cu and W and/or Mo has a partial region on which a naturally oxidized film of Cu is formed, but which has a low resin bonding strength.

For these reasons, many approaches for improving resin bonding properties of metallic materials, such as Al or Cu, have been tried, and various methods have been proposed. For example, in Japanese Unexamined Patent Application Publication Nos. S61-295692 and S61-295693, there are disclosed methods of improving bonding strength between a base member and a resin insulating layer by depositing or plating an Al layer having a thickness of approximately 500 µm on one surface of the base member of an invar plate or copper-plated invar plate, and forming wiring circuits with an insulating layer of epoxy resin, etc.

In addition, in Japanese Unexamined Patent Application Publication No. H10-284643, there is disclosed a method of improving bonding strength by forming an Al coating layer made of crystalline particles having a diameter of 0.1 to 10 µm on a Cu-W or Cu-Mo alloy, and forming an oxidation layer having a thickness of 10 to 800 Å on a surface of the Al coating layer.

However, as the operating speed of semiconductor elements has recently been further increased, a larger amount of heat is generated from the semiconductor elements. Therefore, a further increase of the resin bonding strength between the substrate and the package is requred further compared with that in a conventional method. In particular, less deterrioration of the that the resin bonding strength is required even after a reliability test, such as the HAST.

### [Patent Document 1]

Japanese Unexamined Patent Application Publication No. S61-295692

### [Patent Document 2]

Japanese Unexamined Patent Application Publication No. S61-295693

### [Patent Document 3]

Japanese Unexamined Patent Application Publication No. H10-284643

### Disclosure of Invention

In consideration of the aforementioned conventional problems, an object of the present invention is to provide a member for a semiconductor device made of an alloy or composite of Cu-W, Cu-Mo, Al-SiC, Si-SiC, etc. wherein the member has an excellent resin bonding property capable of improving resin bonding strength at the time the member for a semiconductor device being bonded to another member with resin and maintains a high resin bonding strength even after various reliability tests, such as a thermal cycling test, are performed, and to provide a semiconductor device employing the member.

In order to achieve the object, according to one aspect, the present invention provides a member for a semiconductor device having an excellent resin bonding property, comprising a base member made of an alloy or composite mainly composed of Cu and W and/or Mo, wherein a coating layer made of a hard carbon film is provided on at least a surface of the base member on which another member for the semiconductor device is bonded with a resin. It is preferable that the alloy or composite mainly composed of Cu and W and/or Mo contain Cu of 5 to 40% by weight.

In addition, according to another aspect, the present invention provides a member for a semiconductor device having an excellent resin bonding property, comprising a base member made of an alloy or composite mainly composed of Al-SiC, wherein a coating layer made of a hard carbon film is provided on at least a surface of the base member on which another member for the semiconductor device is bonded with a resin. It is preferable that the alloy or composite mainly composed of Al-SiC contain SiC of 10 to 70% by weight.

Furthermore, according to still another aspect, the present invention provides a member for a semiconductor device having an excellent resin bonding property, comprising a base member made of an alloy or composite mainly composed of Si-SiC, wherein a coating layer made of a hard carbon film is provided on at least a surface of the base member on which another member for the semiconductor device is bonded with a resin. It is preferable that the alloy or composite mainly composed of Si-SiC contain Si of 10 to 35% by weight.

In any one of the members for a semiconductor device according to the aspects, it is preferable that the coating layer have a thickness of 0.1 to 10 µm. It is preferable that the surface of the base member on which the coating layer is formed have a surface roughness of 0.1 to 20 µm in Rmax. Also, it is preferable that pores in the surface of the base member on which the coating layer is formed have a depth of 100 µm or less. Further, it is preferable that a plating layer of Ni be provided between the coating layer and the surface of the base member on which the coating layer is formed.

In addition, according to further still another aspect, the present invention provides a semiconductor device employing the member for a semiconductor device according to the aforementioned aspects.

### Brief Description of Drawings

Figure 1 is a schematic sectional view showing an example of a member for a semiconductor device according to the present invention;
Figure 2 is a schematic sectional view showing a semiconductor device having the member for a semiconductor device of Fig. 1 bonded to a package with resin; and
Figure 3 is a graph showing the resin bonding strength of a coating layer provided on a surface of a base member.

### Best Mode for Carrying Out the Invention

In the present invention, a base member of a member for a semiconductor device is made of an alloy or composite mainly composed of Cu and W and/or Mo, an alloy or composite mainly composed of Al-SiC, and an alloy or composite mainly composed of Si-SiC. These alloys or composites have a thermal expansion coefficient approximate to those of materials for semiconductor elements and package, and also an excellent thermal conductivity. In the present invention, when the member for a semiconductor device comprising a base member made of these alloys or composites is bonded to other members, such as a package, with resin, a coating layer made of a hard carbon film is provided on at least a surface of the base member which is to be bonded with the resin, so that the resin bonding strength can be improved.

The hard carbon film is an amorphous carbon film called diamond-like carbon, amorphous carbon, i-C, or DLC (diamond-like carbon). The hard carbon is neither crystalline carbon, such as graphite, nor diamond itself. The hard carbon film has many properties similar to those of diamond. In particular, the hard carbon film is a very hard material having a Knoop strength of 2,000 to 10,000 kg/mm².

If the hard carbon film is provided as a coating layer to the surface of the base member of the alloys or composites, it is possible to increase the resin bonding strength between the resin and the member for a semiconductor device comprising a base member made of the alloy or composite mainly composed of one of W-Cu, Mo-Cu, Al-SiC, and Si-SiC. In addition, since the resin bonding strength measured after various reliability tests such as a thermal cycling test is not largely deteriorated, it is possible to maintain high resin bonding strength. Such an excellent high resin bonding property is understood to be derived from an extremely slow reaction velocity of the hard carbon film and the resin.

The coating layer comprising the hard carbon film has a thickness of preferably 0.1 to 10 µm, more preferably, 0.5 to 1.5 µm. If the thickness of the hard carbon film is below 0.1 µm, a high resin bonding strength can not be obtained. Particularly, when the thickness is 0.5 µm or more, a preferable resin bonding strength is obtained. In addition, it is undesirrable that the thickness of the hard carbon film exceed 10 µm because the productivity is lowered. Since the hard carbon film has a high compressive stress, a thicker film has higher stress, so it can easily be peeled off. Therefore, it is preferable that the thickness of the hard carbon film be below 1.5 µm.

The hard carbon film can be formed by using a plasma CVD method, or an ion beam deposition method, for example. The plasma CVD method is a method of generating plasma of a carbon-containing source material with high frequency discharge, direct current discharge, or microwave discharge and depositing the carbon on the surface of the base member. Since the surface of the base member is irradiated and activated with plasma, the plasma CVD method can advantageously form the film at a lower temperature compared with a thermal CVD method or the like. On the other hand, the ion beam deposition method is a method of generating plasma from an ion source of hydrocarbon material such as methane, accelerating the plasma at a discharge electrode system to form ion beams, and irradiating and depositing the ion beams on the surface of the base member. In the ion beam deposition method, as the accelerated ion energy is high, the carbon can further infiltrate the base member compared with general deposition methods. Therefore, the ion beam deposition method advantageously has an excellent bonding property to the base member.

Comparing the plasma CVD method with the ion beam deposition method, both of the methods have a common point in generating plasma from a source material. However, in the plasma CVD method, since the plasma is not discharged as an ion beam but directly deposited on the base member in the same space, the film is rapidly formed and the productivity remarkably increases. That is, the film formation velocity in the plasma CVD method is three times or more faster than that of the ion beam deposition method, and a throughput per batch in the plasma CVD method is several to tens times higher than that of the ion beam deposition method. In addition, since both of the plasma CVD method and the ion beam method can form the hard carbon film at a low temperature of 200°C or less, the quality of the base member is not deteriorated.

The base member having the coating layer comprising the hard carbon film formed thereon is one of an alloy or composite mainly composed of Cu and W and/or Mo, an alloy or composite mainly composed of Al-SiC, and an alloy or composite mainly composed of Si-SiC, which conventionally have been used as a substrate material. For example, the alloy or composite mainly composed of Cu and W and/or Mo is disclosed in Japanese Unexamined Patent Application Publication No. S59-21032, No. S59-46050, etc. In addition, the alloy or composite mainly composed of Al-SiC is disclosed in Japanese Unexamined Patent Application Publication No. H10-335538, etc. The alloy or composite mainly composed of Si-SiC is disclosed in Japanese Unexamined Patent Application Publication No. H11-166214, etc.

With respect to a method of manufacturing the hard carbon film, the alloy or composite mainly composed of Cu and W and/or Mo can be manufactured by an infiltration method or a sintering method. In the infiltration method, W or/and Mo powder having Cu powder added thereto is sintered, and Cu is infiltrated into an obtained skeleton. In the sintering method, a compact of W and/or Mo powder and Cu powder is sintered. Also, the alloy or composite mainly composed of Al-SiC can be manufactured by a method, such as a casting method, an immersion method, or a sintering method. In the immersion method, Al is immersed into a preform of SiC. In the sintering method, a compact of Al powder and SiC powder or a compact of an Al-SiC alloy or composite is sintered. In addition, the alloy or composite mainly composed of Si-SiC can be manufactured by a method, such as a casting method, an immersion method, or a sintering method. In the immersion method, Si is immersed into a preform of SiC. In the sintering method, a compact of Si powder and SiC powder or a compact of an Si-SiC alloy or composite is sintered.

These alloys or composites have excellent thermal conductivity as well as a thermal expansion coefficient approximate to those of materials for semiconductor elements and packages. For example, the alloy or composite mainly composed of Cu and W and/or Mo has a thermal expansion coefficient of typically 5x10⁻⁶ to 12x10⁻⁶/°C in the case of the Cu content being in a range of 5 to 40% by weight. The alloy or composite mainly composed of Al-SiC has a thermal expansion coefficient of 8x10⁻⁶ to 20x10⁻⁶/°C in the case of the SiC content being in a range of 10 to 70% by weight. The alloy or composite mainly composed of Si-SiC has a thermal expansion coefficient of 5x10⁻⁶/°C or less over a wide range of content, and particularly, a high thermal conductivity of 200 W/m·K or more in the case of the Si content being in a range of 10 to 35% by weight.

On the other hand, a generally used semiconductor element made of Si, Ge, GaAs, etc. has a thermal expansion coefficient of approximately 3x10⁻⁶ to 4x10⁻⁶/°C. A package member bonded to a substrate has a thermal expansion coefficient of approximately 4x10⁻⁶ to 10x10⁻⁶/°C in the case of a generally used ceramic package and approximately 7x10⁻⁶ to 13x10⁻⁶/°C in the case of a plastic package. Therefore, it is preferable that the alloy or composite mainly composed of Cu and W and/or Mo contain Cu of 5 to 40% by weight. It is preferable that the alloy or composite mainly composed of Al-SiC contain SiC of 10 to 70% by weight. It is preferable that the alloy or composite mainly composed of Si-SiC contain SiC of 10 to 35% by weight.

Preferably, the surface of the base member on which the coating layer of the hard carbon film is formed, is controlled to have surface roughness of 0.1 to 20 µm in Rmax (maximum height) in accordance with the JIS specification. If the surface roughness is less than 0.1 µm in Rmax, a sufficient anchoring effect cannot be obtained even if the coating layer comprising the hard carbon film is formed on the surface. Also, if the surface roughness is more than 20 µm in Rmax, adsorption gases, such as oxygen, increase, so a large amount of gases is released during the coating layer formation. Therefore, it is difficult to obtain the degree of vacuum required for the film formation. In addition, the adhesion between the base member and the coating layer may be lowered. However, in general, if the surface roughness is more than 8 µm in Rmax, voids between resin and the surface of the base member are easily formed during the resin bonding, so variations of the resin bonding strength may increase. Therefore, it is more preferable that the surface roughness is kept at 0.1 to 8 µm in Rmax.

In addition, in order to satisfy the condition of the surface roughness of the base member, it is preferable that pores formed in the surface of the base member have a depth of 100 µm or less. If the pores have a depth of more than 100 µm, the amount of the adsorption gases on the surface of the base member increases, and it is difficult to form a uniform thickness of the coating layer on the base member. Therefore, pits may be created on the surface of the coating layer. In addition, since sufficient bonding resin does not penetrate, it is difficult to maintain a sufficient resin bonding strength.

Furthermore, in order to ensure the bonding strength between the base member and the hard carbon film by providing corrosion resistance to the base member, a plating layer of Ni or the like is formed on the surface of the base member, which is made of an alloy or composite mainly composed of Cu and W and/or Mo, an alloy or composite mainly composed of Al-SiC, or an alloy or composite mainly composed of Si-SiC. More specifically, it is preferable that electrolytic Ni plating or non-electrolytic Ni-P or Ni-B plating is performed to have a film thickness of 1 to 2 µm.

In addition, in order to improve the adhesion of the hard carbon film, an intermediate layer may be formed between the hard carbon film and the base member or the plating layer of Ni or the like on the surface of the base member. For example, the intermediate layer is made of amorphous silicon, polycrystalline silicon, Ge, SiC, or the like. It is preferable that the thickness of the intermediate layer be in a range of approximately 5 to 500 nm. If the thickness is less than 5 nm, it is difficult to coat the surface of the base member completely, so the intermediate layer cannot have a remarkable effect. Even though the upper limit of the thickness may be several micrometers, it is preferable that the thickness be 500 nm or less in consideration of the productivity.

The intermediate layer may be formed by using any conventional film formation method including, for example, a PVD method and a CVD method. In this case, it is effective that the intermediate layer and the hard carbon film are continuously formed within the same vacuum chamber or within a multilayered vacuum apparatus without releasing the vacuum of the apparatus to the atmospheric pressure. Since this does not allow the base member to be exposed to the atmosphere, improved adhesion between the intermediate layer and the hard carbon film can be expected.

The resin used to bond the member for a semiconductor device according to the present invention, where the hard carbon film is provided on the surface of the base member, to another member, such as a package, includes, for example, epoxy resin to which a silver filler or a ceramic filler such as silica is added, epoxy resin to which silicon resin is added to reduce Young's modulus, epoxy resin without the aforementioned addition, polyimide resin with the aforementioned addition, polyimide resin without the addition, phenol resin with the aforementioned addition, phenol resin without the addition, polyester resin with the aforementioned addition, polyester resin without the addition, silicon resin with the aforementioned addition, and silicon resin without the addition.

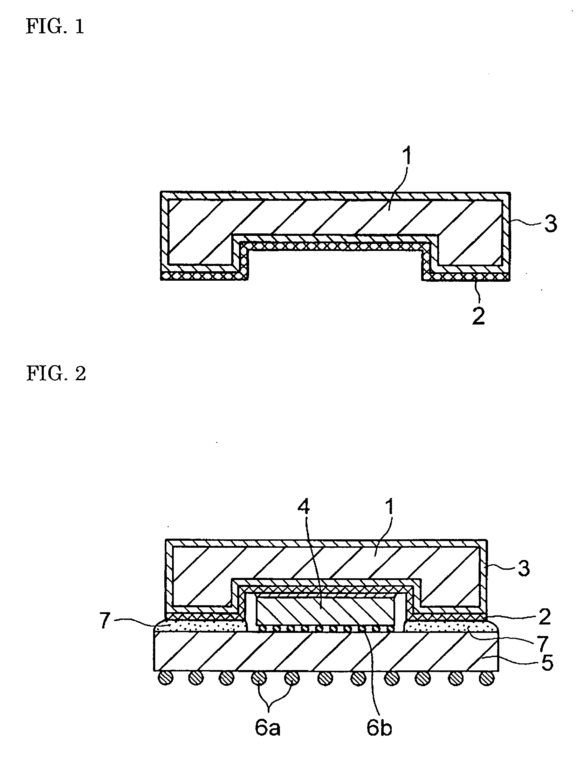

A semiconductor device can be manufactured by using a member according to the present invention, where a hard carbon film is provided on the surface of the base member. For example, as shown in Fig. 1, an Ni plating layer 3 having a thickness of 1 to 2 µm is formed over the entire surface of a base member 1. Next, coating layer made of a hard carbon (DLC) film 2 is formed on one surface of the base member including an element-mounting portion by using a plasma CVD method. Typically, the hard carbon film contains H (hydrogen) of 30 to 40 atomic percent. As shown in Fig. 2, a semiconductor element 4 is mounted on a central region of the one surface of the base member on which the hard carbon film 2 is provided. Next, an outer periphery of the surface of the base member on which the hard carbon film 2 is provided, is bonded to a front surface of a ceramic package 5 with an epoxy resin 7. Further, in Fig. 2, reference numeral 6a indicates solder bumps formed on a rear surface of the ceramic package 5, and reference numeral 6b indicates solder bumps for electrically connecting the semiconductor element 4 to the ceramic package 5.

### Example

Composites having compositions shown in the Table given below were prepared to be used as base members of a member for a semiconductor device. More specifically, Cu-W or Cu-Mo composites were manufactured to have a substantially 100% concentration by using an infiltration method. An Al-SiC composite was manufactured by using a sintering method. In addition, a Si-SiC composite was manufactured by the infiltration method.

These composites are machined in the shape of plates having a dimension of 100 mm (length) x 25 mm (width) x 2 mm (height). The surfaces of the plates were subjected to grinding or blasting, so these composites have the values shown in the Table in a range of a surface roughness of 0.5 to 100 µm in Rmax. The samples 1 to 17 of the present invention were obtained by forming a coating layer made of a hard carbon (DLC) film having a thickness shown in the Table on the surface of each of the base members using a plasma CVD method. In addition, as comparative examples, instead of forming the abovementioned DLC film, the sample 18 was obtained by forming an Ni layer on the surface of a base member using electrolytic nickel plating, and the sample 19 was obtained by forming an Al layer on the surface of a base member using a vapor deposition method.

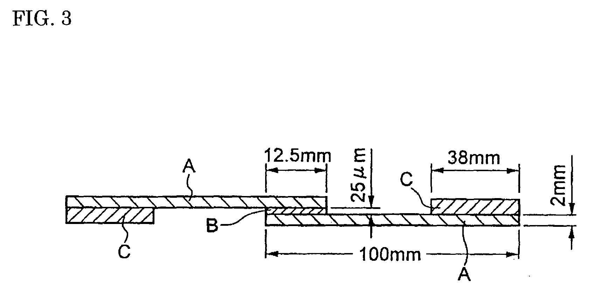

The obtained samples were evaluated for resin bonding strength in accordance with JIS K 6850 as follows. A used resin is a liquid epoxy resin containing a silver filler of 70% by weight. As shown in Fig. 3, the epoxy resin B having a thickness of 25 µm was applied to one end of each of two sample substrates A. The two samples A were bonded to each other with the epoxy resin B and cured at 180°C for one hour. After the epoxy resin was cured, drying was performed at 150°C for 24 hours to obtain the test pieces.

The test pieces obtained according to JIS K 6850 were examined for an initial bonding strength and bonding strengths after a thermal cycling test, a pressure cooker test (PCT), and a highly accelerated stress test (HAST). The results are shown in the Table given below. The thermal cycling test was performed for 1,000 cycles in an atmosphere of 150°C for 30 minutes and an atmosphere of -65°C for 30 minutes. The PCT was performed for 300 hours in partial-saturation type PCT conditions of 121°C, 100% RH, and 2 atm. In addition, the HAST was performed for 300 hours at 131°C, 85% RH, and 2 atm.

The measurement of the bonding strength was performed with a precision universal tester (Autograph). Specifically, as shown in Fig. 3, the holding regions C at both ends of a test piece, to which two test substrates A are bonded, were held with grips of the tester. The test piece was pulled at a rate of 50 mm/min in the direction of a major axis thereof while taking care to keep the major axis of the test piece and the central line of the grips on the same straight line. The maximum load when the test piece was broken was recorded. The maximum load was divided by the area of a portion on the test piece to which the resin was adhered, so the obtained quotient was taken as the bonding strength.

**Table**

| Sample | Substrate material (wt%) | Rmax (µm) | DLC film (µm) | Resin bonding strength (kgf/mm²) | | | |
|---|---|---|---|---|---|---|---|
| | | | | Initial strength (kgf/mm²) | Strength after thermal cycling test (kgf/mm²) | Strength after PCT (kgf/mm²) | Strength after HAST (kgf/mm²) |
| 1 | 10% Cu-W | 5 | 1.0 | 1.8 | 1.5 | 1.3 | 1.3 |
| 2 | 15% Cu-W | 5 | 1.0 | 1.9 | 1.5 | 1.3 | 1.3 |
| 3 | 20% Cu-W | 5 | 1.0 | 1.8 | 1.5 | 1.3 | 1.3 |
| 4 | 10% Cu-Mo | 5 | 1.0 | 1.9 | 1.5 | 1.3 | 1.3 |
| 5 | 15% Cu-Mo | 5 | 1.0 | 1.9 | 1.5 | 1.3 | 1.3 |
| 6 | 20% Cu-Mo | 5 | 1.0 | 1.8 | 1.5 | 1.3 | 1.3 |
| 7 | 30% Al-SiC | 5 | 1.0 | 1.8 | 1.5 | 1.3 | 1.3 |
| 8 | 20% Si-SiC | 5 | 1.0 | 1.8 | 1.5 | 1.3 | 1.3 |
| 9 | 10% Cu-W | 0.05 | 1.0 | 1.5 | 1.2 | 1.1 | 1.0 |
| 10 | 10% Cu-W | 1 | 1.0 | 1.6 | 1.4 | 1.2 | 1.1 |
| 11 | 10% Cu-W | 10 | 1.0 | 1.7 | 1.4 | 1.2 | 1.1 |
| 12 | 10% Cu-W | 30 | 1.0 | 1.7 | 1.3 | 1.2 | 1.0 |
| 13 | 10% Cu-W | 5 | 0.05 | 1.5 | 1.4 | 1.1 | 1.0 |
| 14 | 10% Cu-W | 5 | 0.1 | 1.6 | 1.4 | 1.2 | 1.1 |
| 15 | 10% Cu-W | 5 | 2 | 1.7 | 1.5 | 1.4 | 1.3 |
| 16 | 10% Cu-W | 5 | 5 | 1.5 | 1.3 | 1.2 | 1.0 |
| 17 | 10% Cu-W | 5 | 15 | 1.5 | 1.3 | 1.0 | 1.0 |
| 18* | 10% Cu-W | 5 | Ni/1.0 | 1.4 | 0.9 | 0.7 | 0.4 |
| 19* | 10% Cu-W | 5 | Al/1.0 | 1.8 | 1.1 | 0.9 | 0.8 |
| Note; Samples of comparative examples are indicated by symbol *. | | | | | | | |

The primarily important resin bonding strength is the initial bonding strength at the time of the resin bonding. In general, the allowable initial bonding strength is 1.5 kgf/mm² or more in shear strength. In addition, the shear strengths after the thermal cycling test, the PCT, and the HAST are important. For example, the allowable shear strengths after the thermal cycling test of 1,000 cycles, the PCT for 300 hours, and the HAST for 300 hours are 1.0 kgf/mm² or more, which is sufficiently practicable.

As can be understood from the results in the Table, in all the samples 1 to 17 of the present invention, the initial bonding strengths and the bonding strengths after the reliability tests satisfied the aforementioned condition of the shear strength, and good resin bonding strengths were obtained.

On the other hand, the comparative sample 18, in which a Ni layer is formed, had an initial resin bonding strength of 1.5 kgf/mm² or less, and had a resin bonding strength of 1.0 kgf/mm² or less after the thermal cycling test, the PCT, and the HAST. In addition, the comparative sample 19 , in which an Al layer is formed, had a resin bonding strength of 1.0 kgf/mm² or more from the initial stage to the thermal cycling test stage, but had a resin bonding strength of 1.0 kgf/mm² or less after the PCT and the HAST, so the resin bonding strength was severely deteriorated.

### Industrial Applicability

According to the present invention, it is possible to provide a member for a semiconductor device made of a Cu-W or Cu-Mo alloy or composite, an Al-SiC alloy or composite, or an Si-SiC alloy or composite, which has an excellent thermal conductivity and thermal expansion, wherein the member is capable of improving resin bonding strength at the time the member for a semiconductor device being bonded to another member with resin and maintaining a high resin bonding strength even after various reliability tests, such as a thermal cycling test, wherein a semiconductor device employing the member can be provided.

## Claims

1. A member for a semiconductor device comprising a base member made of an alloy or composite mainly composed of Cu and W and/or Mo, wherein a coating layer made of a hard carbon film is provided on at least a surface of the base member on which another member for the semiconductor device is bonded with a resin.

2. The member for a semiconductor device according to claim 1, wherein the alloy or composite mainly composed of Cu and W and/or Mo contains Cu of 5 to 40% by weight.

3. A member for a semiconductor device comprising a base member made of an alloy or composite mainly composed of Al-SiC, wherein a coating layer made of a hard carbon film is provided on at least a surface of the base member on which another member for the semiconductor device is bonded with a resin.

4. The member for a semiconductor device according to claim 3, wherein the alloy or composite mainly composed of Al-SiC contains SiC of 10 to 70% by weight.

5. A member for a semiconductor device comprising a base member made of an alloy or composite mainly composed of Si-SiC, wherein a coating layer made of a hard carbon film is provided on at least a surface of the base member on which another member for the semiconductor device is bonded with a resin.

6. The member for a semiconductor device according to claim 5, wherein the alloy or composite mainly composed of Si-SiC contains Si of 10 to 35% by weight.

7. The member for a semiconductor device according to any one of claims 1 to 6, wherein the coating layer has a thickness of 0.1 to 10 µm.

8. The member for a semiconductor device according to any one of claims 1 to 7, wherein the surface of the base member on which the coating layer is formed has a surface roughness of 0.1 to 20 µm in Rmax.

9. The member for a semiconductor device according to any one of claims 1 to 8, wherein pores in the surface of the base member on which the coating layer is formed have a depth of 100 µm or less.

10. The member for a semiconductor device according to any one of claims 1 to 9, wherein a plating layer of Ni is provided between the coating layer and the surface of the base member on which the coating layer is formed.

11. A semiconductor device employing the member for a semiconductor device according to any one of claims 1 to 10.
